(19) **Europäisches Patentamt / European Patent Office / Office européen des brevets**

(11) **EP 2 136 217 B1**

(12) **EUROPÄISCHE PATENTSCHRIFT**

(45) Veröffentlichungstag und Bekanntmachung des Hinweises auf die Patenterteilung:
**18.08.2010 Patentblatt 2010/33**

(51) Int Cl.:
**G01R 19/20** *(2006.01)* **G01R 15/18** *(2006.01)*

(21) Anmeldenummer: **09162659.8**

(22) Anmeldetag: **15.06.2009**

(54) **Stromsensoranordnung zur Messung von Strömen in einem Primärleiter**

Electricity sensor assembly for measuring currents in a primary conductor

Agencement de capteur de courant pour mesurer des courants dans un conducteur primaire

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **20.06.2008 DE 102008029477**

(43) Veröffentlichungstag der Anmeldung:
**23.12.2009 Patentblatt 2009/52**

(73) Patentinhaber: **Vacuumschmelze GmbH & Co. KG 63450 Hanau (DE)**

(72) Erfinder: **Dr. Koch, Ralf 36399, Freiensteinau (DE)**

(74) Vertreter: **Patentanwälte Westphal, Mussgnug & Partner Herzog-Wilhelm-Strasse 26 80331 München (DE)**

(56) Entgegenhaltungen:
**EP-A- 1 338 900      DE-A- 3 728 912
DE-A- 4 229 948**

**EP 2 136 217 B1**

**Beschreibung**

Die Erfindung betrifft eine Stromsensoranordnung zur Messung von Strömen in einem Primärleiter über einem weiten Messbereich.

Zur berührungslosen und damit potenzialfreien Messung der Stärke eines elektrischen Stromes in einem Leiter sind zum einen so genannte direktabbildende Stromsensoren bekannt, die den durch den Strom verursachten magnetischen Fluss beispielsweise mittels eines Hallsensors in einem geschlitzten magnetischen Kreis erfassen und ein der Stromstärke proportionales Signal erzeugen. Diese Sensoren sind sehr kostengünstig, weisen aber eine relativ geringe Genauigkeit auf. Direktabbildende Stromsensoren sind so genannte Open-Loop-Stromsensoren, die keinen geschlossenen Regelkreis enthalten.

Des Weiteren sind so genannte Closed-Loop-Stromsensoren bekannt, bei denen mit Hilfe eines geschlossenen Regelkreises kontinuierlich ein magnetisches Gegenfeld gleicher Größe wie das des zu messenden Stromes erzeugt wird, so dass eine vollständige Magnetfeldkompensation auftritt und aus den Parametern zur Erzeugung des Gegenfeldes auf die Größe des zu messenden Stromes geschlossen werden kann. Closed-Loop-Stromsensoren gehören also zur Klasse der Kompensationsstromsensoren.

Eine besondere Art von Kompensationsstromsensoren, die jedoch keinen geschlossenen Regelkreis enthalten, sind Flux-Gate-Sensoren, welche z.B. in der Druckschrift DE 42 29 948 beschrieben sind. Da bei derartigen Stromsensoren ein Hysteresefehler vermieden wird, eignen sie sich zur präzisen Strommessung in einem weiten Dynamikbereich von wenigen Milliampere bis zirka ein Kiloampere.

Flux-Gate-Sensoren ermöglichen keine kontinuierliche Strommessung, sondern das Ausgangssignal des Sensors ist ein periodisches Signal, das zu bestimmten Abtastzeiten abgetastet wird. Die Abtastwerte repräsentieren den Strom in dem Primärleiter (Primärstrom) zu den diskreten Abtastzeitpunkten.

Die Abtastfrequenz ist bei dem bekannten Flux-Gate-Sensor durch die Schwingfrequenz des Sensors (Sensorfrequenz) und folglich durch die Induktivität der Sensoranordnung vorgegeben. Die Induktivität wird häufig groß gewählt, um den Sensor unempfindlicher gegen Störungen zu machen, wodurch die Sensorfrequenz jedoch verhältnismäßig klein wird. Durch die Verwendung kleiner Spulen und Spulenkerne könnte die Induktivität zwar verringert und die Sensorfrequenz erhöht werden, was aber aufgrund der erhöhten Störanfälligkeit kleinerer Kerne häufig nicht realisierbar ist. Das tatsächliche Design bei herkömmlichen Flux-Gate-Sensoren ist also immer ein Kompromiss zwischen den sich widersprechenden Designzielen von erstens hoher Sensorfrequenz (und damit hoher zeitlicher Auflösung) und zweitens großer Induktivität (wegen der geringeren Störanfälligkeit). Das Sensordesign ist für eine bestimmte Anwendung festgelegt und kann während des Betriebes nicht verändert werden.

Ein Problem bei den bekannten Flux-Gate-Sensoren ist der hohe maximale Stromverbrauch aufgrund der periodischen vollständigen Ummagnetisierung der Magnetsystems des Flux-Gate-Sensors, was die Verwendung von Flux-Gate Sensoren für viele Anwendung wirtschaftlich uninteressant macht.

Ein weiteres Problem kann auftreten, wenn die Frequenz des Primärstromes ähnlich oder gleich der Sensorfrequenz oder einem ganzzahligen Vielfachen davon ist. Dann werden im abgetasteten Ausgangssignal des Sensors aufgrund von Aliasing-Effekten Schwebungen sichtbar, die in einem Frequenzbereich liegen, der für die Strommessung wichtig sein können. Diese Schwebungen stören klarerweise die Messung. Dies kann soweit gehen, dass in manchen Fällen eine sinnvolle Strommessung unmöglich wird, wodurch der praktische Anwendungsbereich des Stromsensors stark eingeschränkt ist.

Der Erfindung liegt also die Aufgabe zugrunde, eine flexible Stromsensoranordnung zur Messung von Strömen in einem Primärleiter zur Verfügung zu stellen, bei der die oben beschriebenen Probleme nicht auftreten.

Die Aufgabe wird gelöst durch eine Stromsensoranordnung gemäß Patentanspruch 1 und durch ein Verfahren gemäß Anspruch 5. Weitere Beispiele der Erfindung sind Gegenstand der abhängigen Ansprüche.

Ein Beispiel der Erfindung betrifft eine Stromsensoranordnung zur Messung eines Primärstromes in einem Primärleiter, die folgende Komponenten aufweist: einen ferromagnetischen Kern zur magnetischen Kopplung des Primärleiters an einen Sekundärleiter; eine gesteuerte Spannungsquelle, die mit dem Sekundärleiter verbunden ist; eine mit dem Sekundärleiter verbundene Ansteuereinrichtung zum regelmäßigen ummagnetisieren des ferromagnetischen Kerns, wobei die Ansteuereinrichtung eine gesteuerte Spannungsquelle aufweist, die mit dem Sekundärleiter verbunden und dazu ausgebildet ist eine bipolare Spannung einer bestimmten Amplitude bereitzustellen, sodass ein resultierender Sekundärstrom die Ummagnetisierung des ferromagnetischen Kerns bewirkt; und eine Steuereinrichtung zur Steuerung der Spannungsquelle, wobei die Steuereinrichtung dazu ausgebildet ist, zumindest einmal die Spannungsquelle zu einem Zeitpunkt umzupolen, der vor jenem Zeitpunkt liegt an dem der ferromagnetischen Kern seine Sättigungsmagnetisierung erreicht. Da nicht die vollständige Hysteresekennlinie des ferromagnetischen Kerns durchlaufen wird, spricht man auch von einem Teilhystereseverfahren zur Strommessung.

Ein weiteres Beispiel der Erfindung betrifft ein Verfahren zur Messung eines Primärstromes in einem Primärleiter, der über einen ferromagnetischen Kern magnetisch mit einem Sekundärleiter gekoppelt ist, mit den folgenden Schritten: Anlegen einer Spannung einer bestimmten Amplitude an den Sekundärleiter, sodass ein Sekundärstrom zur Ummagnetisierung des ferromagnetischen Kerns fließt; Messen des Sekundärstromes während des Ummagnetisierens des Kerns um einen ersten Messwert zu erhalten; Umpolen der Spannung, sodass ein Sekundärstrom zur erneuten Ummagnetisierung des ferromagnetischen Kerns fließt; Messen des Sekundärstromes während des Ummagnetisierens des Kerns um einen zweiten Messwert zu erhalten; Berechnen des Primärstromes in Abhängigkeit des ersten und des zweiten Messwertes, wobei zumindest einmal das Umpolen zu einem Zeitpunkt erfolgt, der vor jenem Zeitpunkt liegt an dem der ferromagnetische Kern seine Sättigungsmagnetisierung erreicht.

Die Erfindung wird nachfolgend anhand von Figuren näher erläutert, wobei gleiche Bezugszeichen gleiche Komponenten bzw. Signale bezeichnen. Es zeigt:

Figur 1    zwei Blockschaltbilder von einfachen Ausführungs- beispielen der erfinderischen Stromsensoranordnung;

Figur 2    den Signalverlauf des Sekundärstroms, der Magneti- sierung und der magnetischen Feldstärke bei einer freischwingenden Stromsensoranordnung mit einem Primärstrom von null;

Figur 3    den Signalverlauf des Sekundärstroms, der Magneti- sierung und der magnetischen Feldstärke bei einer freischwingenden Stromsensoranordnung mit einem Primärstrom größer null;

Figur 4    den bei dem Stromsensor möglichen Aliasingeffekt anhand der Signalverläufe von Primär- und Sekundär- strom;

Figur 5    den Signalverlauf des Sekundärstroms, der Magneti- sierung und der magnetischen Feldstärke bei einer Stromsensoranordnung im Teilhysteresebetrieb mit einem Primärstrom von null;

Figur 6    das Ausführungsbeispiel aus Figur 1 im Detail und

Figur 7    den Signalverlauf des Versorgungsstroms und des Stromes in der Sensorwicklung für einen üblichen Stromsensor, einen erfindungsgemäßen Stromsensor und eine Weiterbildung eines erfindungsgemäßen Stromsensors.

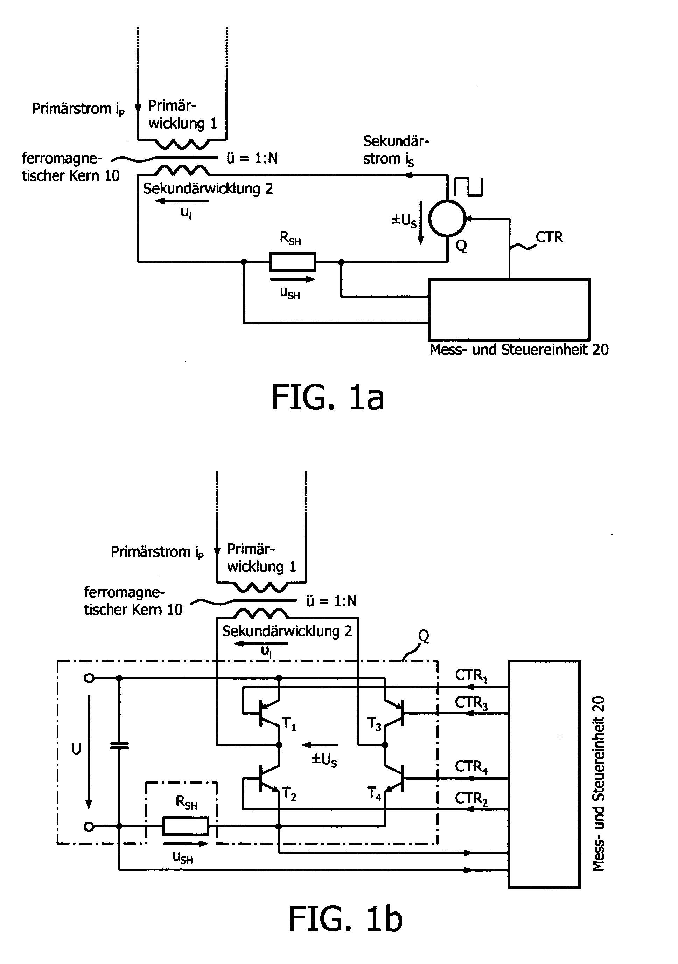

In Figur 1a ist anhand eines Blockschaltbildes der prinzipielle Aufbau eines Kompensationsstromsensors ohne Hysteresefehler dargestellt. Der zu messende Strom (Primärstrom $i_P$) fließt durch eine Primärwicklung 1, die über einen weichmagnetischen und beispielsweise ungeschlitzten Kern 10 magnetisch an eine Sekundärwicklung 2 (Windungszahl N) gekoppelt ist. Die Primärwicklung 1 kann z. B. aus einer einzigen Windung bestehen, d.h. die Primärwicklung 1 wird aus einem Leiter gebildet, der durch den Kern 10 hindurchgeführt ist (Windungszahl 1). Die Sekundärwicklung 2 ist in Serie zu einer gesteuerten Spannungsquelle Q geschalten, die den Sekundärstrom $i_S$ durch die Sekundärwicklung erzeugt. Zur Messung des Sekundärstromes $i_S$ ist zwischen Sekundärwicklung 2 und Spannungsquelle Q ein Shunt-Widerstand $R_{SH}$ geschaltet. Die Spannung $U_{SH}$ über dem Shunt-Widerstand $R_{SH}$ ist einer Mess- und Steuereinheit 20 zugeführt, die auch ein Steuersignal CTR zur Ansteuerung der gesteuerten Spannungsquelle Q bereitstellt.

Die Figur 1b zeigt eine das Beispiel aus Figur 1a mit einer beispielhaften Ausführungsform der gesteuerten Spannungsquelle Q. In diesem Beispiel wird die Polarität der Versorgungsgleichspannung U mit Hilfe einer Transistorvollbrücke bestehend aus den Transistoren $T_1$ bis $T_4$ abhängig von Steuersignalen $CTR_1$ bis $CTR_4$, die von der Mess- und Steuereinheit 20 erzeugt werden, eingestellt. Die Mess- und Steuereinheit 20 ist also in der Lage, die Versorgungsgleichspannung U abhängig von Steuersignalen umzupolen. Aufgrund der induktiven Last der Sekundärwicklung 2 benötigen die Transistoren $T_1$ bis $T_4$ jeweils eine Freilaufdiode. Diese Dioden sind der Übersichtlichkeit wegen nicht extra dargestellt.

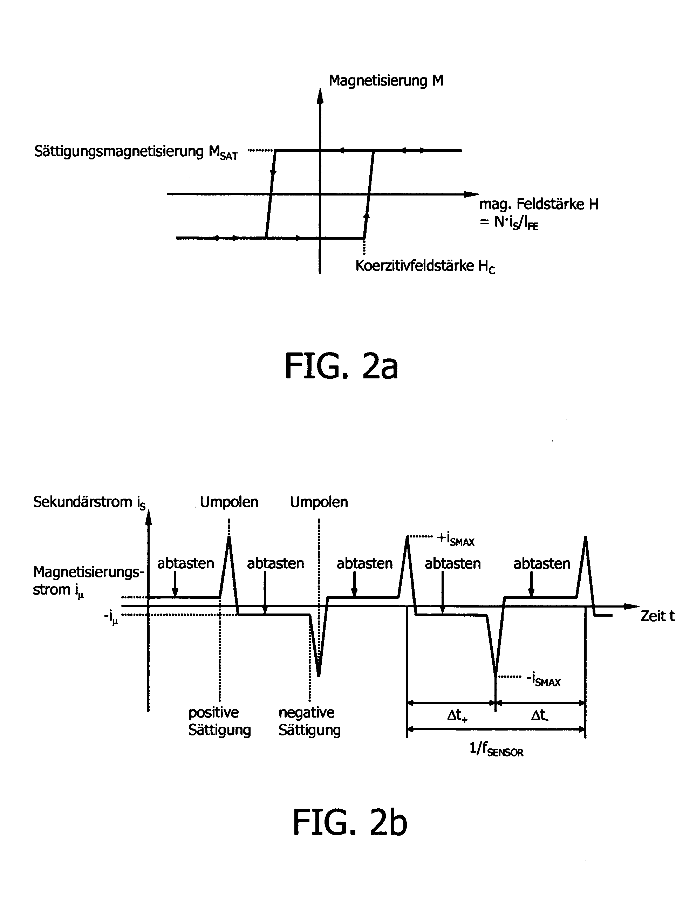

Die Funktionsweise der in den Figuren 1a und 1b dargestellten Strommessanordnungen wird im Folgenden anhand der Figuren 2 bis 4 beschrieben. Figur 2a beschreibt die ferromagnetischen Eigenschaften des weichmagnetischen Kerns 10 anhand einer Magnetisierungskennlinie, wobei auf der Abszisse die magnetische Feldstärke H und auf der Ordinate die Magnetisierung M aufgetragen sind. Die Magnetisierungskennlinie weist eine annähernd rechteckförmige Hysterese auf mit einer bestimmten Koerzitivfeldstärke $H_C$ und einer bestimmten Sättigungsmagnetisierung $M_{SAT}$. Für die magnetische Feldstärke H gilt entsprechend dem Ampère'schen Gesetz vereinfacht $H = N \cdot i_S / l_{FE}$, wobei der Parameter $l_{FE}$ die magnetische Weglänge der Magnetfeldlinien im Kern 10 bezeichnet.

Für die in der Sekundärspule 2 induzierte Spannung $u_i$ gilt entsprechend dem Farady'schen Gesetz

$$u_i = -N \cdot d\Phi/dt = -N \cdot A \cdot dB/dt, \qquad\qquad (1)$$

wobei der Parameter A die Querschnittsfläche des Kerns 10, das Symbol Φ den von dem Sekundärstrom $i_S$ verursachten magnetischen Fluss durch den Kern 10 und das Symbol B die magnetische Flussdichte bezeichnet. Die magnetische Flussdichte B lässt sich allgemein durch die Beziehung $B = \mu_0 \cdot (H+M)$ darstellen; daraus folgt, dass während des Ummagnetisierens des Kerns 10 (entspricht dem linken oder rechten vertikalen Ast der Magnetisierungskennlinie in Figur 2a) die Änderungsrate der Magnetisierung $dM/dt$ proportional zu der induzierten Spannung $u_i$ ist und dabei die magnetische Feldstärke H und somit auch der Sekundärstrom $i_S$ konstant sind, d.h.

$$u_i = -N \cdot A \cdot \mu_0 \cdot dM/dt \qquad \text{(beim Ummagnetisieren)} \qquad (2)$$

Man kann auch sagen die differentielle Induktivität der Sekundärspule 2 ist während des Ummagnetisierens nahezu unendlich groß. Sobald die Magnetisierung im Kern 10 die Sättigungsmagnetisierung $M_{SAT}$ erreicht hat steigt der Sekundärstrom $i_S$ an, und wird nur mehr durch den ohmschen Widerstand der Sekundärwicklung 2 und den Shunt-Widerstand $R_{SH}$ begrenzt.

Das Ansteigen des Sekundärstroms $i_S$ wird von der Mess- und Steuereinheit 20 beispielsweise mit Hilfe von Komparatoren erkannt (vgl. Figur 2b). Sobald der Sekundärstrom einen positiven Schwellwert $+i_{SMAX}$ überschreitet oder einen negativen Schwellwert $-i_{SMAX}$ unterschreitet erzeugt die Mess- und Steuereinheit 20 ein entsprechendes Steuersignal CTR um die Spannungsquelle Q umzupolen und den nächsten Ummagnetisierungszyklus einzuleiten.

Der zeitliche Verlauf des Sekundärstromes bei einem Primärstrom $i_P$ von null ist in Figur 2b dargestellt. Während des Ummagnetisierens (vgl. annähernd vertikale Äste der Magnetisierungskennlinie aus Figur 2a) ist der Sekundärstrom konstant und entspricht dem Magnetisierungsstrom $+i_\mu$ bzw. $-i_\mu$. Der Betrag des Magnetisierungsstrom $i_\mu$ hängt von der Breite der Hysterese in der Magnetisierungskennlinie, also von der Koerzitivfeldstärke $H_C$, ab, d.h. $i_\mu = l_{FE}/N \cdot H_C$. Sobald die Magnetisierung im Kern 10 die positive oder negative Sättigungsmagnetisierung erreicht beginnt der Sekundärstrom $i_S$ anzusteigen, wie oben bereits beschrieben. Aufgrund der Symmetrie der Hysteresekennlinie ist der zeitliche Verlauf des Sekundärstroms $i_S$ auch symmetrisch um einen mittleren Stromwert.

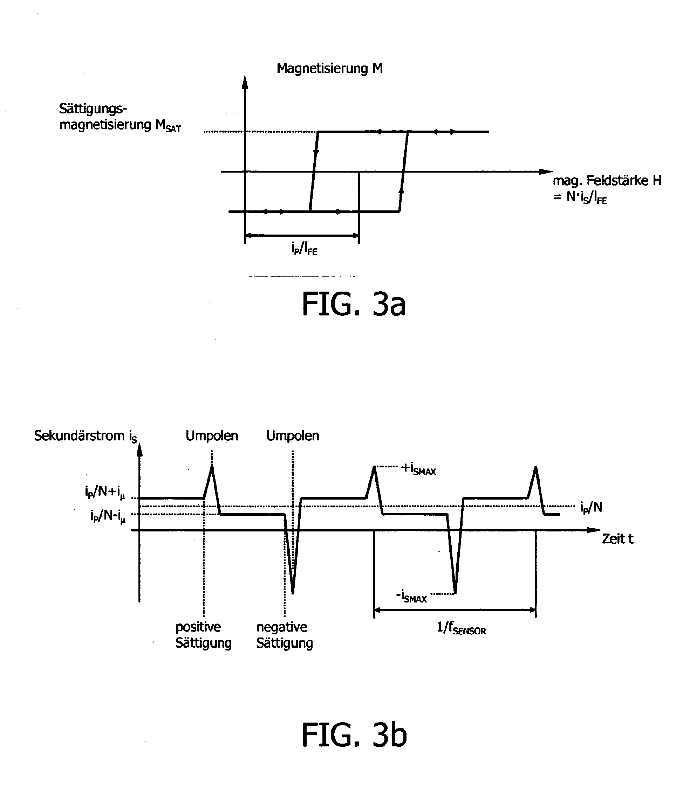

Die Figuren 3a und 3b zeigen den gleichen Sachverhalt wie die Figuren 2a und 2b, jedoch für einen Primärstrom $i_P$ ungleich null. Das von dem Primärstrom $i_P$ erzeugte Magnetfeld überlagert sich in dem weichmagnetischen Kern 10 additiv dem Magnetfeld des Sekundärstromes $i_S$, was als Verschiebung der Magnetisierungskennlinie entlang der Abszisse dargestellt werden kann. Dieser Sachverhalt ist in Figur 3a bildlich dargestellt. Der korrespondierende zeitliche Verlauf des Sekundärstromes ist in Figur 3b dargestellt. Dieser ist ähnlich wie in Figur 2b bei einem Primärstrom von null mit dem Unterschied, dass der Sekundärstrom nicht mehr symmetrisch um die Abszisse ($i_S$=0) verläuft, sondern symmetrisch um die horizontale Gerade ($i_S = i_P/N$). Das heißt während des Ummagnetisierens stehen Primärstrom und Sekundärstrom im selben Verhältnis ü=1:N wie die Wicklungszahlen von Primärwicklung 1 und Sekundärwicklung 2, mit Ausnahme des Hysterese-Offsets in der Höhe des Magnetisierungsstroms $i_\mu$. Zur Strommessung wird das Sekundärstromsignal $i_S$, genau genommen das Spannungssignal $u_{SH}$ am Shunt-Widerstand $R_{SH}$, während des Ummagnetisierungsvorganges abgetastet. So erhält man in der ersten Hälfte einer Periode des Sekundärstromes einen Strommesswert $i_S[n-1]=(i_P/N)+i_\mu$ und in der zweiten Periodenhälfte einen Strommesswert $i_S[n]=(i_P/N)-i_\mu$. Durch Mittelwertbildung lässt sich der Hysteresefehler, der durch den Magnetisierungsstrom verursacht wird eliminieren, der Primärstrom zu einem Abtastzeitpunkt n berechnet sich wie folgt:

$$i_P[n] = N \cdot (i_S[n-1]+i_S[n])/2. \qquad (3)$$

Dadurch dass die Hysterese der Magnetisierungskennlinie auf das Messergebnis keinen Einfluss hat, eignet sich dieses Strommessverfahren sehr gut zur Messung sehr kleiner Ströme. Der Messbereich reicht von einigen Milliampere bis hin zu einem Kiloampere. Während des Ummagnetisierungsvorganges im Kern 10 folgt der Sekundärstrom $i_S$ dem Primärstrom $i_P$ entsprechend dem Übertragungsverhältnis 1:ü. Der Sekundärstrom wird währenddessen zumindest einmal abgetastet um einen Messwert ($i_S+i_\mu$ bzw. $i_S-i_\mu$) zur Berechnung des Primärstromes zu erhalten. Während des Ummagnetisierens kann die Abtastung aber auch wiederholt mit einer Abtastrate erfolgen, die wesentlich höher ist, als die Schwingfrequenz des Sensor selbst, beispielsweise mit Abtastfrequenzen zwischen 1 kHz und 1 MHz. So ist es möglich auch transiente Vorgänge im Primärstromsignal $i_P$ zu erfassen, solange diese transienten Vorgänge während des Ummagnetisierens auftreten. Während der Kern 10 in magnetischer Sättigung ist, ist keine sinnvolle Strommessung möglich.

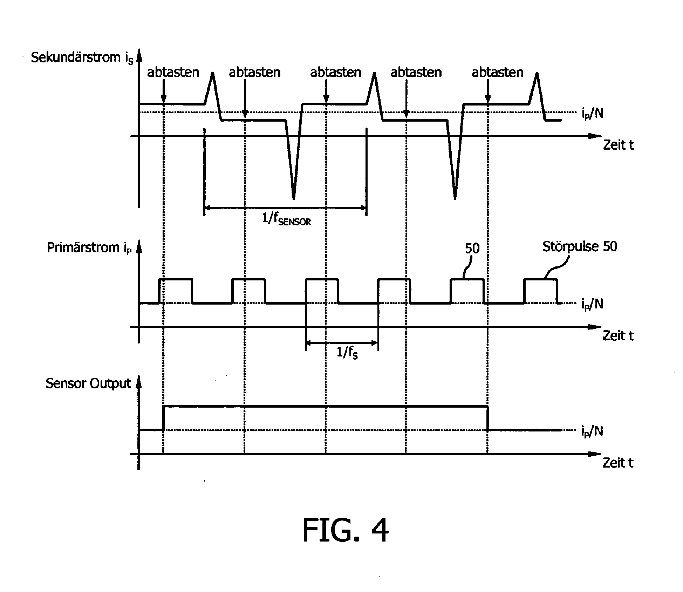

Aufgrund der Tatsache, dass die oben beschriebene Stromsensoranordnung keine kontinuierliche Messung erlaubt sondern den Sekundärstrom nur zu diskreten Zeitpunkten abgetastet wird, können unerwünschte Aliasing-Effekte auftreten, die sich im Messergebnis vor allem als niederfrequente Schwebungen manifestieren. Die Abtastung kann beispielsweise immer eine feste Zeit nach dem Umpolen der Spannung $U_S$ der Stromquelle Q ausgelöst werden, wobei die Zeit so kurz gewählt werden kann, dass der Sekundärstrom $i_S$ eingeschwungen ist, d.h. dem Primärstrom $i_P$ folgt. Die erwähnte Aliasing-Problematik ist beispielhaft in Figur 4 dargestellt.

Ist die Frequenz des Primärstromes $i_P$ gleich oder zumindest ähnlich groß wie die Schwingfrequenz der Sensoranordnung, d.h. des Sekundärstromes $i_S$, oder wie ein ganzzahliges Vielfaches davon, dann können unerwünschte Schwebungen das Messsignal überlagern, sodass keine vernünftige Messung möglich ist. Im vorliegenden Fall ist der Primärstrom $i_P$ mit einem Rechtecksignal moduliert, dessen Frequenz in einer ähnlichen Größenordnung liegt, wie die doppelte Schwingfrequenz $f_{SENSOR}$ des Stromsensors, d.h. nahe der Abtastfrequenz. In diesem Fall kommt es zu Aliasing-Effekten, die sich als niederfrequente Schwebungen in einem Frequenzbereich auswirken, der für die Messung wichtig ist.

In dem in der Figur 4 gezeigten Beispiel sind dem Primärstrom $i_P$ Störimpulse 50 mit überlagert, die sich mit einer Frequenz $f_S$ wiederholen. Die Frequenz $f_S$ der Störimpulse 50 liegt in einer ähnlichen Größenordnung wie die doppelte Sensorschwingfrequenz $f_{SENSOR}$. Der Unterschied zwischen $f_S$ und $2f_{SENSOR}$ ist gerade so groß, dass sich eine Schwebung mit einer Schwebungsfrequenz von rund der halben Sensorfrequenz ergibt. Wäre der Unterschied geringer, ist die Schwebungsfrequenz klarerweise och geringer. Eine Anti-Aliasing-Filterung wie z.B. in Nachrichtensystemen ist bei einer derartigen Stromsensoranordnung jedoch nicht möglich.

Aus G1. (2) ist erkennbar, dass die Geschwindigkeit des Ummagnetisierungsvorganges umso höher ist, je höher die Amplitude $U_S$ der von der Spannungsquelle Q erzeugten Spannung ist, denn aus G1. (2) folgt:

$$dM/dt \; = \; -u_i/(N \cdot A \cdot \mu_0) \; = \; -(U_S - R_{SH} \cdot i_s)/(N \cdot A \cdot \mu_0) \, . \qquad (4)$$

Folglich ist die Schwingfrequenz des Sekundärstromes umso höher, je höher die Amplitude $U_S$ der von der Spannungsquelle Q erzeugten Spannung ist. Die Schwingfrequenz $f_{SENSOR}$ des Sensors folgt aus G1. (4):

$$f_{SENSOR} \; = \; \Delta t_+ \; + \; \Delta t_-, \qquad (5a)$$

wobei

$$\Delta t_+ \; = \; (\mu_0 \cdot \Delta M \cdot N \cdot A)/(U_S - i_P \cdot R_{SH}/N) \qquad (5b)$$

$$\Delta t_- \; = \; (\mu_0 \cdot \Delta M \cdot N \cdot A)/(U_S + i_P \cdot R_{SH}/N) \, . \qquad (5c)$$

Der Parameter $\Delta M$ ist dabei der Magnetisierungshub während eines Ummagnetisierungsvorganges. Aus den G1. (5a) und (5b) ist erkennbar, dass die Schwingfrequenz $f_{SENSOR}$ des Sensors einerseits von dem Primärstrom selbst, als auch von der Spannungsamplitude $U_S$ der von der Spannungsquelle Q erzeugten Spannung und von dem Magnetisierungshub $\Delta M$ abhängt.

Wenn in einem konkreten Anwendungsfall die Signalfrequenz des Primärstromes $i_P$ ähnlich oder gleich groß ist wie die Schwingfrequenz $f_{SENSOR}$ des Sensors oder ein Vielfaches davon, dann kann, um den in Figur 4 beschriebenen unerwünschten Aliasingeffekt zu vermeiden die Schwingfrequenz $f_{SENSOR}$ durch eine Veränderung der Spannungsamplitude $U_S$ oder des Magnetisierungshubes $\Delta M$ entsprechend angepasst werden, um unerwünschte Effekte zu vermeiden.

Bei einer freischwingenden Stromsensoranordnung, deren Sekundärstromverlauf in Figur 2 gezeigt ist, ist der Magnetisierungshub $\Delta M$ durch die Sättigungsmagnetisierung $M_{SAT}$ vorgegeben ($\Delta M = 2 \cdot M_{SAT}$), sodass eine Variation der Schwingfrequenz $f_{SENSOR}$ in einfacher Weise über eine Variation der Spannungsamplitude $U_S$ der Stromquelle Q erfolgen kann. Die Spannungsamplitude wird beispielsweise über ein Steuersignal von der Mess- und Steuereinheit 20 so angesteuert, dass die Schwingfrequenz $f_{SENSOR}$ der Stromsensoranordnung während des Betriebes laufend variiert. So kann erreicht werden, dass eine Störung 50 mit einer bestimmten Frequenz im abgetasteten Sensorsignal (Messsignal) nicht mehr als Schwebung erscheint. Stattdessen sind im Messsignal nur mehr unregelmäßige Störpulse zu sehen, die jedoch die Messung - im Gegensatz zu der Schwebung - nicht ernsthaft beeinträchtigen.

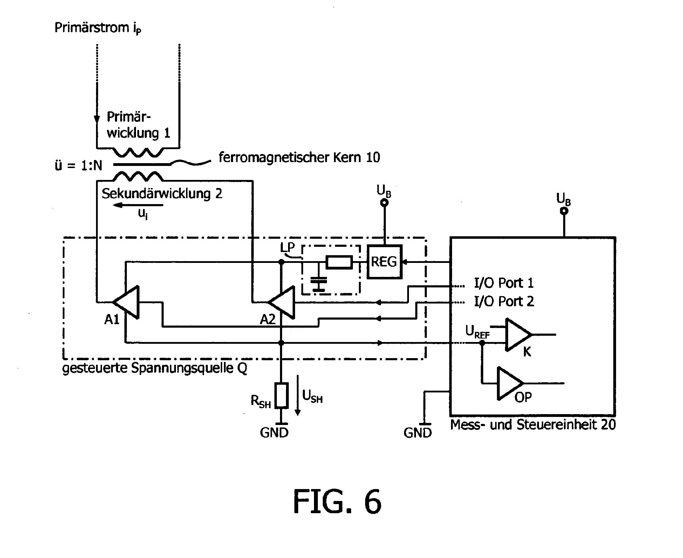

Das Variieren bzw. Anpassen der Sensorfrequenz $f_{SENSOR}$ wird von der Mess- und Steuereinheit 20 gesteuert (vgl. Figuren 1 und 6). Die Mess- und Steuereinheit 20 kann beispielsweise dazu ausgebildet sein, die Sensorfrequenz $f_{SENSOR}$ stochastisch zu variieren. Alternativ kann die Sensorfrequenz $f_{SENSOR}$ auch nach einem bestimmten, vorgegebenen Frequenzmuster zu variiert werden. Dies kann beispielsweise dadurch erreicht werden, indem die Steuereinrichtung die Amplitude der Spannungsquelle Q (siehe Figur 1) amplitudenmoduliert, wodurch die Sensorfrequenz $f_{SENSOR}$ frequenzmoduliert wird. Generell kann durch eine Veränderung der Spannungsamplitude der Spannungsquelle Q die Sensorfrequenz in einem gewissen Bereich verändert werden (vgl. Gleichungen 5a-c). Ist die Frequenz $f_S$ einer Störung 50 (vgl. Figur 4) bekannt kann es sinnvoll sein, die Mess- und Steuereinheit 20 so auszugestalten, dass die Sensorfrequenz $f_{SENSOR}$ oder ein ganzzahliges Vielfaches davon sich so stark von der Frequenz $f_S$ der Störung 50 unterscheidet, dass die resultierende Schwebung in einem Frequenzbereich auftritt, der für die Messung nicht relevant ist, beispielsweise in einem Frequenzbereich oberhalb des für die Messung interessierenden Frequenzbereiches.

Eine Variation der Sensorfrequenz löst bzw. reduziert zwar die negativen Auswirkungen von eventuell vorhandenen Aliasing-Effekten, dennoch ist der Stromverbrauch bei freischwingenden Flux-Gate-Sensoren, wie z.B. in der Figur 4 erläutert verhältnismäßig hoch, was die Anwendung dieser Sensoren für viele Applikationen uninteressant macht.

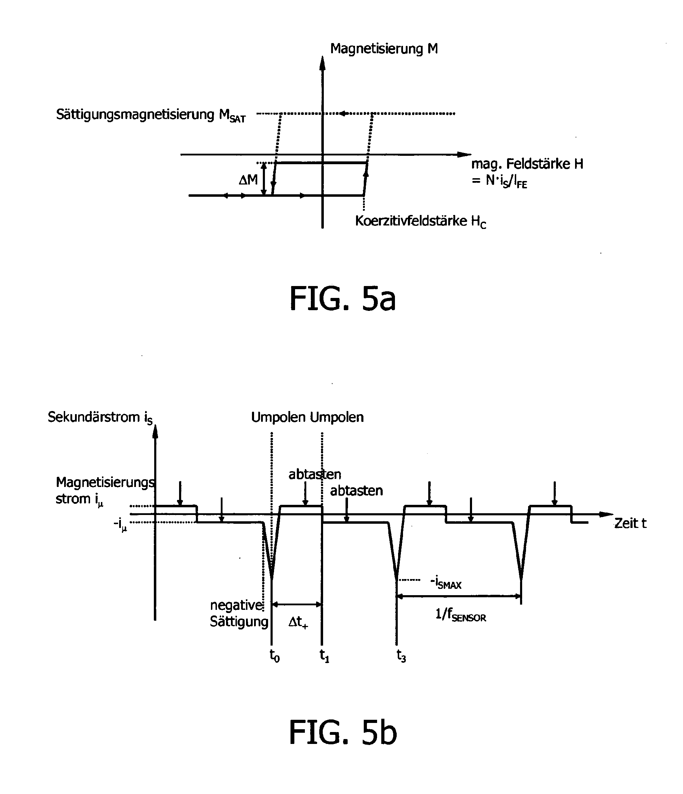

Die Figuren 5a-c betreffen ein sogenanntes TeilhystereseVerfahren zum Betrieb eines Flux-Gate-Sensors, bei dem der Stromverbrauch der im Vergleich zu bekannten Flux-Gate-Sensoren nennenswert reduziert ist.

Wie in den Figuren 3b, 4b und 5b zu sehen ist, ist die gewünschte Information über den Primärstrom $i_P$ schon bereits im Sekundärstrom $i_S$ vorhanden und ablesbar, lange bevor die gesamte Hysteresekurve durchlaufen wurde. Das vollständige Ummagnetisieren des Spulenkerns 10, was ja die wesentliche Ursache für die hohe Leistungsaufnahme von freischwingenden Flux-Gate-Sensoren ist, ist zur eigentlichen Messwerterfassung also nicht notwendig.

Eine vorteilhafte Reduktion der Leistungsaufnahme des Stromsensors kann also erreicht werden, wenn die Spannung der Spannungsquelle Q nicht erst nach vollständiger Sättigung des Magnetkerns 10 (wie bei dem Beispiel aus Figur 4), sondern bereits zuvor wieder umgepolt wird. Das heißt, die Zeitspanne $\Delta t_+$ (oder alternativ $\Delta t_-$) einer Periode des Sekundärstromes $i_S$ wird direkt von der Mess- und Steuereinheit 20 vorgegeben und nicht wie in dem Beispiel aus Figur 4 durch einen Schwellwert eines Komparators bestimmt. Wie oben bereits erläutert, wird dadurch direkt der Magnetisierungshub AM festgelegt (vgl. Gleichung 5a bzw. 5b). Beim TeilhystereseBetrieb der Flux-Gate-Sensoranordnung erfolgt zumindest der Ummagnetisierungsvorgang in einer Richtung zeitgesteuert. Dadurch wird erreicht, dass nicht mehr die gesamte Hysterese der Magnetisierungskennlinie durchlaufen wird (vgl. Figuren 2a und 3a), sondern nur ein Teil der Hysterese, beispielsweise 20 bis 30 Prozent. Dadurch, dass im Vergleich zur freischwingenden Sensoranordnung nur ein Bruchteil des Magnetisierungshubes AM auftritt, ist der Strombedarf und die Verlustleistung beim Teilhysteresebetrieb deutlich geringer als bei der freischwingenden Sensoranordnung.

Bei der Teilhysteresemethode ist zumindest der Teil $\Delta t_+$ oder alternativ $\Delta t_-$ der Periodendauer $f_{SENSOR}^{-1}$ der Sensorschwingfrequenz vorgegeben, d.h. die Spannungsquelle Q wird nach einer bestimmten Zeit $\Delta t_+$ umgepolt, bevor der Kern 10 sein Sättigungsmagnetisierung $M_{SAT}$ erreicht. Daraufhin wird der weichmagnetische Kern 10 wieder bis zur Sättigungsmagnetisierung - $M_{SAT}$ ummagnetisiert und der Zyklus beginnt von vorne. Im Prinzip könnte auch das Ummagnetisieren in beide Richtungen zeitgesteuert erfolgen, dann kann es jedoch passieren, dass der tatsächlich durchlaufene Teil der Hysteresekurve aufgrund von unvermeidbaren Ungenauigkeiten innerhalb der gesamten Hysteresekurve "driftet". Um immer von einem bestimmten Referenzpunkt der Hysteresekurve die Ummagnetisierung zu starten, kann zumindest jeder zweite Ummagnetisierungsvorgang (wie in dem Beispiel aus Figur 3) komparatorgesteuert erfolgen, nachdem der Kern bis in die Sättigung magnetisiert wurde.

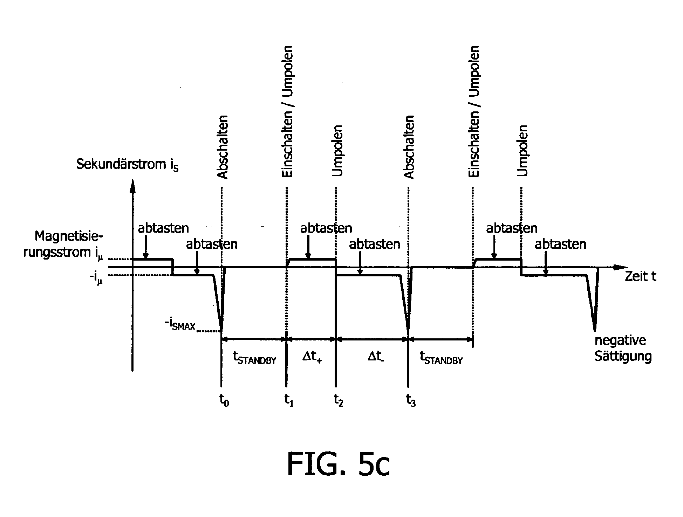

In der Figur 5c ist eine Variante der in Figur 5b dargestellten Funktionsweise dargestellt, mit der im Teilhysteresebetrieb noch eine weitere Reduktion des Strombedarfs und der Leistungsaufnahme erreicht werden kann. Nach dem Ende einer Periode des Primärstromsignals, zu einem Zeitpunkt $t_0$, beginnt im Gegensatz zu der Variante aus Figur 5b kein neuer Ummagnetisierungszyklus, sondern die Spannungsquelle Q wird zum Zeitpunkt $t_0$ für eine Zeitspanne $t_{STANDBY}$ abgeschalten. Am Ende dieser Pause, zu einem Zeitpunkt $t_1$, wird die Spannungsquelle Q mit umgekehrter Polarität wieder eingeschalten und ein neuer Ummagnetisierungsvorgang startet. Das Magnetisieren des Kernes 10 wird dann eine von der Steuer- und Messeinheit 20 eine bestimmte Zeit $\Delta t_+$ lang bis zum Zeitpunkt $t_2$ fortgesetzt und danach die Spannungsquelle Q wieder umgepolt. Zu dem Zeitpunkt $t_2$ ist der Kern noch nicht vollständig ummagnetisiert, der durchlaufene Magnetisierungshub $\Delta M$ beträgt rund 20% bis 30% des maximal möglichen Magnetisierungshubes bei vollständiger Ummagnetisierung. Ab dem Zeitpunkt $t_2$ erfolgt eine weitere, diesmal vollständige Ummagnetisierung bis in die (negative) Sättigungsgrenze, um, wie bereits erwähnt, wieder einen definierten Referenzpunkt der Hysteresekennlinie zu erreichen.

Im übrigen funktioniert ein Sensor, der nach der Teilhysteresemethode arbeitet, gleich wie bereits anhand der Figuren 2 und 3 beschrieben. Der einzige unterschied besteht darin, dass nur die Ummagnetisierung in eine Richtung durch einen Komparator gesteuert erfolgt, wie bei der Methode aus Figur 2, die Ummagnetisierung in die andere Richtung erfolgt zeitgesteuert durch eine Vorgabe der Zeitspanne $\Delta t_+$ bzw. $\Delta t_-$, wodurch der Magnetisierungshub $\Delta M$ entsprechend der G1. 5b eingestellt wird.

Analog zu dem oben beschriebenen Fall, bei dem eine Anpassung der Spannungsamplitude $U_S$ erfolgt, kann bei der Teilhysteresemethode der Magnetisierungshub $\Delta M$ über die Zeitspanne $\Delta t_+$ (bzw. $\Delta t_-$) beispielsweise über ein Steuersignal CTR von der Mess- und Steuereinheit 20 so angepasst werden, dass die Schwingfrequenz $f_{SENSOR}$ der Stromsensoranordnung während des Betriebes ständig variiert wird. Auch in diesem Fall kann die Variation der Sensorfrequenz $f_{SENSOR}$ über eine Variation des Magnetisierungshubes $\Delta M$ bzw. des Zeitpunktes des Umpolens der Spannungsquelle Q zufällig oder nach einem bestimmten Frequenzmuster erfolgen.

Analog zu der oben beschriebenen Amplitudenmodulation der Spannung $U_S$ der Stromquelle Q kann bei der Teilhysteresemethode der Magnetisierungshub $\Delta M$ über eine Modulation der Zeitspanne $\Delta t_+$ bzw. $\Delta t_-$ moduliert werden. Um eine Frequenzmodulation der Sensorfrequenz $f_{SENSOR}$ zu erreichen kann der Zeitpunkt des Umpolens der Spannungsquelle Q um einen Mittelwert moduliert werden. Ist die Frequenz $f_S$ einer Störung 50 (vgl. Figur 4) bekannt, kann die Sensorfrequenz $f_{SENSOR}$ so eingestellt werden, dass sie oder ein ganzzahliges Vielfaches davon sich so stark von der Frequenz $f_S$ der Störung 50 unterscheidet, dass die resultierende Schwebung in einem Frequenzbereich auftritt, der für die Messung nicht relevant ist.

Alternativ zu einer Variation der Zeitspanne $\Delta t_+$ bzw. $\Delta t_-$ kann, bei dem in Figur 5b gezeigten Beispiel auch die Pausenzeit $t_{STANDBY}$ variiert werden, um die Sensorfrequenz zu variieren.

Figur 6 zeigt ein Beispiel einer praktischen Implementierung der Sensoranordnung aus FIG. 1. Die Spannungsquelle Q wird aus zwei Gegentaktendstufen A1 und A2 mit niederohmigen Ausgangswiderstand gebildet, die über einen Spannungsregler REG versorgt werden. An den Ausgängen der beiden Endstufen A1 und A2 ist jeweils ein Anschluss der Sekundärwicklung 2 verbunden. Der Shunt-Widerstand $R_{SH}$ ist in den Versorgungsstrompfad der Endstufen geschaltet, im vorliegenden Fall ist ein Anschluss des Shunt-Widerstandes $R_{SH}$ mit dem Massepotential verbunden um ein massebezogenes Stromsignal $U_{SH}$ zu erhalten. Das Stromsignal $U_{SH}$, d.h. die über dem Shunt-Widerstandes $R_{SH}$ abfallende Spannung ist der Mess- und Steuereinheit 20 zugeführt. Die Eingänge der Gegentaktendstufen sind mit je einem I/O Port der Mess- und Steuereinheit 20 verbunden und werden immer gegensinnig angesteuert.

In den Versorgungsstrompfad der Endstufen kann optional ein Tiefpass LP geschaltet sein, um den Strom in den Versorgungsleitungen zu mitteln und den maximalen Strombedarf, der aus der Versorgungsspannungsquelle $U_B$ gedeckt werden muss zu begrenzen. Der Spitzenstrom wird aus dem Kondensator geliefert, die Versorgungsspannungsquelle $U_B$ muss nur die verbrauchte Verlustleistung decken. Der Blindstrom beim Ummagnetisieren des Kerns wird großteils wieder in den Kondensator zurückgespeist. Im einfachsten Fall kann der Tiefpass aus einem Kondensator und einem Widerstand (RC-Glied) bestehen. Der Widerstand kann auch durch eine Diode ersetzt werden.

Die Mess- und Steuereinheit 20 umfasst auch einen Verstärker OP zum Verstärken des Strommesssignals $U_{SH}$. Dieses ist beispielsweise einem ADC zugeführt, um einen digitalen Messwert zu erhalten. Zum Bestimmen des Zeitpunktes einer Ummagnetisierung des weichmagnetischen Kerns 10 kann die Mess- und Steuereinheit 20 auch einen Komparator K aufweisen, der das Strommesssignal $U_{SH}$ mit einem Referenzsignal $U_{REF}$ vergleicht, das den maximalen Sekundärstromwert $i_{SMAX}$ repräsentiert.

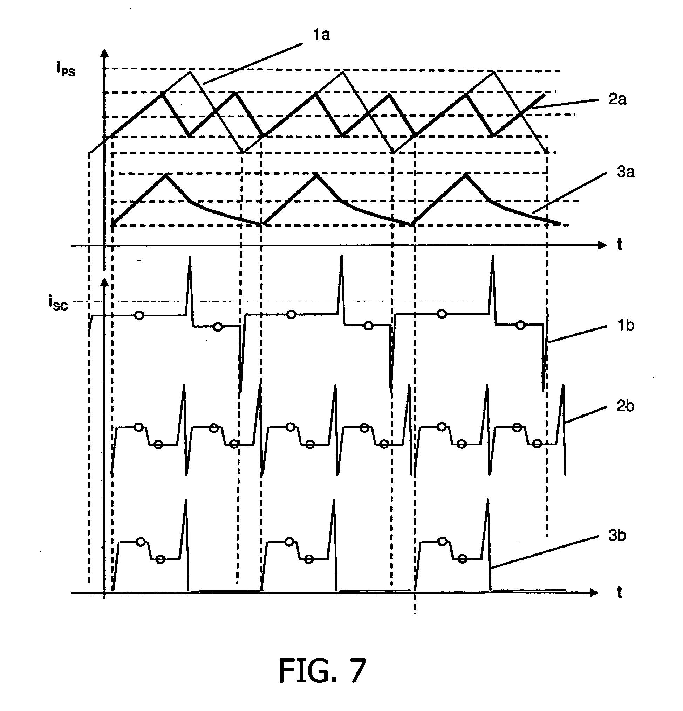

Figur 7 zeigt hierzu den Signalverlauf des Versorgungsstroms $i_{PS}$ und des Stromes $i_{SC}$ in der Sensorwicklung über der Zeit t für einen üblichen Stromsensor (Kurven 1a und 1b), einen erfindungsgemäßen Stromsensor (2a und 2b) und eine Weiterbil-dung eines erfindungsgemäßen Stromsensors (3a und 3b). Die Weiterbildung ist dabei derart, dass wie oben bereits beschrieben zumindest einmal die Spannungsquelle zu einem Zeitpunkt abgeschaltet wird, sobald der ferromagnetischen Kern seine Sättigungsmagnetisierung erreicht und nach Ablauf einer Pausenzeit die Spannungsquelle mit umgekehrter Polarität wieder eingeschaltet wird.

**Patentansprüche**

1.  Stromsensoranordnung zur Messung eines Primärstromes in einem Primärleiter, die aufweist:

    einen ferromagnetischen Kern zur magnetischen Kopplung des Primärleiters an einen Sekundärleiter;
    eine gesteuerte Spannungsquelle, die mit dem Sekundärleiter verbunden ist;
    eine mit dem Sekundärleiter verbundene Ansteuereinrichtung zum regelmäßigen ummagnetisieren des ferromagnetischen Kerns, wobei die Ansteuereinrichtung eine gesteuerte Spannungsquelle aufweist, die mit dem Sekundärleiter verbunden und dazu ausgebildet ist eine bipolare Spannung einer bestimmten Amplitude bereitzustellen, sodass ein resultierender Sekundärstrom die Ummagnetisierung des ferromagnetischen Kerns bewirkt; und
    eine Steuereinrichtung zur Steuerung der Spannungsquelle, wobei die Steuereinrichtung dazu ausgebildet ist, zumindest einmal die Spannungsquelle zu einem Zeitpunkt umzupolen, der vor jenem Zeitpunkt liegt an dem der ferromagnetischen Kern seine Sättigungsmagnetisierung erreicht so dass nicht die gesamte Hysterese der Magnetisierungskennlinie durchlaufen wird.

2.  Stromsensoranordnung nach Anspruch 1, bei der die Steuereinrichtung dazu ausgebildet ist, zumindest einmal die Spannungsquelle zu einem Zeitpunkt abzuschalten, sobald der ferromagnetischen Kern seine Sättigungsmagnetisierung erreicht und nach Ablauf einer Pausenzeit die Spannungsquelle mit umgekehrter Polarität wieder einzuschalten.

3. Stromsensoranordnung nach Anspruch 1, bei der die Steuereinrichtung dazu ausgebildet ist, zumindest einmal die Spannungsquelle zu einem Zeitpunkt umzupolen, sobald der ferromagnetischen Kern seine Sättigungsmagnetisierung erreicht.

4. Stromsensoranordnung nach einem der Ansprüche 1 bis 3, bei der die gesteuerte Spannungsquelle einen Tiefpass aufweist, um den von einer Versorgungsspannungsquelle bereitzustellenden maximalen Laststrom zu begrenzen.

5. Stromsensoranordnung nach einem der Ansprüche 1 bis 4, bei der die Steuereinrichtung dazu ausgebildet ist, eine Sensorfrequenz, welche der Sekundärstrom aufweist, während des Betriebes der Stromsensoranordnung zu variieren.

6. Stromsensoranordnung nach Anspruch 5, bei der die Steuereinrichtung dazu ausgebildet ist, die Sensorfrequenz stochastisch zu variieren.

7. Stromsensoranordnung nach Anspruch 5, bei der die Steuereinrichtung dazu ausgebildet ist, die Sensorfrequenz nach einem bestimmten Frequenzmuster zu variieren.

8. Stromsensoranordnung nach Anspruch 5, bei der
der Primärstrom Signalanteile einer bestimmten Signalfrequenz aufweist und bei der
die Steuereinrichtung dazu ausgebildet ist, die Sensorfrequenz in Abhängigkeit von der Signalfrequenz so zu variieren, dass sich die Sensorfrequenz oder ein ganzzahliges Vielfaches davon von der Signalfrequenz unterscheidet.

9. Stromsensoranordnung nach einem der Ansprüche 5 bis 8, bei der die Steuereinrichtung dazu ausgebildet ist, die Spannungsamplitude der Spannungsquelle zu variieren, wodurch die Sensorfrequenz variiert wird.

10. Stromsensoranordnung nach einem der Ansprüche 5 bis 9, bei der die Steuereinrichtung dazu ausgebildet ist, den Zeitpunkt des Umpolens der Spannungsquelle zu variieren, wodurch die Sensorfrequenz variiert wird.

11. Verfahren zur Messung eines Primärstromes in einem Primärleiter, der über einen ferromagnetischen Kern magnetisch mit einem Sekundärleiter gekoppelt ist, mit den folgenden Schritten:

Anlegen einer Spannung einer bestimmten Amplitude an den Sekundärleiter, sodass ein Sekundärstrom zur Ummagnetisierung des ferromagnetischen Kerns fließt;
Messen des Sekundärstromes während des Ummagnetisierens des Kerns um einen ersten Messwert zu erhalten;
Umpolen der Spannung, sodass ein Sekundärstrom zur erneuten Ummagnetisierung des ferromagnetischen Kerns fließt;
Messen des Sekundärstromes während des Ummagnetisierens des Kerns um einen zweiten Messwert zu erhalten;
Berechnen des Primärstromes in Abhängigkeit des ersten und des zweiten Messwertes,
wobei zumindest einmal das Umpolen zu einem Zeitpunkt erfolgt, der vor jenem Zeitpunkt liegt an dem der ferromagnetischen Kern seine Sättigungsmagnetisierung erreicht so dass nicht die gesamte Hysterese der Magnetisierungskennlinie durch laufen wird.

12. Verfahren nach Anspruch 11, bei dem zumindest einmal das Umpolen zu einem Zeitpunkt erfolgt, sobald der ferromagnetischen Kern seine Sättigungsmagnetisierung erreicht.

13. Verfahren nach Anspruch 11, bei dem zumindest einmal die Spannungsquelle zu einem Zeitpunkt abgeschaltet wird, sobald der ferromagnetischen Kern seine Sättigungsmagnetisierung erreicht und nach Ablauf einer Pausenzeit die Spannungsquelle mit umgekehrter Polarität wieder eingeschaltet wird.

14. Verfahren nach einem der Ansprüche 11 bis 13, bei dem der Sekundärstrom von einer Spannungsquellenschaltung bereitgestellt wird, wobei das Verfahren zusätzlich umfasst:

Tiefpassfiltern eines Versorgungsstromes der Spannungsquellenschaltung, um den von einer Versorgungsspannungsquelle bereitzustellenden maximalen Laststrom zu begrenzen.

**15.** Verfahren nach einem der Ansprüche 11 bis 14, wobei das Umpolen der Spannung regelmäßig mit einer bestimmten Sensorfrequenz erfolgt und die Sensorfrequenz laufend variiert wird.

**16.** Verfahren nach Anspruch 15, bei dem die Sensorfrequenz stochastisch variiert wird.

**17.** Verfahren nach Anspruch 15, bei dem die Sensorfrequenz nach einem bestimmten Frequenzmuster variiert wird.

**Claims**

**1.** A current sensor assembly for measuring a primary current in a primary conductor, which includes:

A ferromagnetic core for magnetically coupling the primary conductor to a secondary conductor;
A controlled voltage source, which is connected to the secondary conductor;
An activating device connected to the secondary conductor for regularly reversing the magnetisation of the ferromagnetic core, wherein the activating device includes a controlled voltage source, which is connected to the secondary conductor and is constructed to provide a bipolar voltage of a predetermined amplitude so that a resulting secondary current effects the reversal of the magnetisation of the ferromagnetic core; and
A control device for controlling the voltage source, wherein the control device is constructed to reverse the polarity of the voltage source at least once at a time which is before the time at which the ferromagnetic core reaches its saturation magnetisation so that the full hysteresis of the magnetisation curve is not covered.

**2.** A current sensor assembly as claimed in claim 1, in which the control device is constructed to switch off the voltage source at least once at a time as soon as the ferromagnetic core reaches its saturation magnetisation and to switch the voltage source on with a reversed polarity after the elapse of a pause period.

**3.** A current sensor assembly as claimed in claim 1, in which the control device is constructed to reverse the polarity of the voltage source at least once at a time as soon as the ferromagnetic core reaches its saturation magnetisation.

**4.** A current sensor assembly as claimed in one of claims 1 to 3, in which the controlled voltage source includes a low-pass filter in order to limit the maximum load current to be provided from a voltage supply source.

**5.** A current sensor assembly as claimed in claim 1 of claims 1 to 4, in which the control device is constructed to vary a sensor frequency, which the secondary current exhibits, during the operation of the current sensor assembly.

**6.** A current sensor assembly as claimed in claim 5, in which the control device is constructed to vary the sensor frequency stochastically.

**7.** A current sensor assembly as claimed in claim 5, in which the control device is constructed to vary the sensor frequency in accordance with a predetermined frequency pattern.

**8.** A current sensor assembly as claimed in claim 5, in which the primary current includes signal components of a predetermined signal frequency and in which the control device is constructed to vary the sensor frequency in dependence on the signal frequency so that the sensor frequency or a whole number multiple thereof differs from the signal frequency.

**9.** A current sensor assembly as claimed in one of claims 5 to 8, in which the control device is constructed to vary the voltage amplitude of the voltage source, whereby the sensor frequency is varied.

**10.** A current sensor assembly as claimed in one of claims 5 to 9, in which the control device is constructed to vary the timing of the reversal of polarity of the voltage source, whereby the sensor frequency is varied.

**11.** A method of measuring a primary current in a primary conductor, which is magnetically coupled via a ferromagnetic core with a secondary conductor, with the following steps:

Applying a voltage of a predetermined amplitude to the secondary conductor so that a secondary current flows for the reversal of the magnetisation of the ferromagnetic core;

Measuring the secondary current during the reversal of the magnetisation of the core in order to obtain a first measured value;

Reversing the polarity of the voltage so that a secondary current flows for the further reversal of the magnetisation of the ferromagnetic core;

Measuring the secondary current during the reversal of the magnetisation of the core in order to obtain a second measured value;

Calculating the primary current in dependence on the first and second measured values, wherein the reversal of the polarity occurs at least once at a time which is before the time at which the ferromagnetic core reaches its saturation magnetisation so that the entire hysteresis of the magnetisation curve is not covered.

12. A method as claimed in claim 11, in which the reversal of the polarity occurs at least once at a time as soon as the ferromagnetic core reaches its saturation magnetisation.

13. A method as claimed in claim 11, in which the voltage source is switched off at least once at a time as soon as the ferromagnetic core reaches its saturation magnetisation and the voltage source is switched on again with reversed polarity after elapse of a pause period.

14. A method as claimed in one of claims 11 to 13, I which the secondary current is provided by a voltage source circuit, wherein the method additionally includes: low-pass filtering a supply current from the voltage source circuit in order to limit the maximum load current to be supplied by a voltage supply source.

15. A method as claimed in one of claims 11 to 14, wherein the reversal of the polarity of the voltage occurs regularly with a predetermined sensor frequency and the sensor frequency is continuously varied.

16. A method as claimed in claim 15, in which the sensor frequency is varied stochastically.

17. A method as claimed in claim 15, in which the sensor frequency is varied in accordance with a predetermined frequency pattern.

**Revendications**

1. Montage de capteur de courant pour mesurer un courant primaire dans un conducteur primaire comprenant :

- un noyau ferromagnétique pour le couplage magnétique du conducteur primaire sur un conducteur secondaire,
- une source de tension commandée, reliée au conducteur primaire,
- une installation de commande reliée au conducteur secondaire pour inverser régulièrement l'aimantation du noyau ferromagnétique,
* l'installation de commande ayant une source de tension commandée reliée au conducteur secondaire et fournissant une tension bipolaire d'une amplitude déterminée de façon que le courant secondaire résultant, inverse l'aimantation du noyau ferromagnétique, et
- une installation de commande pour commander la source de tension,
* l'installation de commande étant réalisée pour inverser au moins une fois la polarité de la source de tension à un instant situé en amont de l'instant auquel le noyau ferromagnétique atteint sa saturation magnétique de façon à ne pas parcourir toute la boucle d'hystérésis de la courbe d'aimantation.

2. Montage de capteur de courant selon la revendication 1,
selon lequel
l'installation de commande est réalisée pour couper au moins une fois la source de tension à un instant dès que le noyau ferromagnétique atteint sa saturation magnétique et à la fin d'un temps de pause, à brancher de nouveau la source de tension avec une polarité inversée.

3. Montage de capteur de courant selon la revendication 1,
selon lequel
l'installation de commande est réalisée pour inverser au moins une fois la polarité de la source de tension à un instant dès que le noyau ferromagnétique a atteint sa saturation d'aimantation.

**4.** Montage de capteur de courant selon l'une des revendications 1 à 3, selon lequel
la source de tension commandée comporte un filtre passe-bas pour limiter le courant maximum de charge fourni par une source de tension d'alimentation.

**5.** Montage de capteur de courant selon l'une des revendications 1 à 4, selon lequel
l'installation de commande est réalisée pour varier la fréquence du capteur pour le courant secondaire pendant le fonctionnement du dispositif de capteur de courant.

**6.** Montage de capteur de courant selon la revendication 5,
selon lequel
l'installation de commande est réalisée pour varier la fréquence de capteur de manière stochastique.

**7.** Montage de capteur de courant selon la revendication 5,
selon lequel
l'installation de commande est réalisée pour varier la fréquence de capteur selon un motif de fréquence déterminé.

**8.** Montage de capteur de courant selon la revendication 5,
selon lequel

- la composant de signal du courant primaire présente une certaine fréquence de signal, et
- l'installation de commande est réalisée pour varier la fréquence du capteur en fonction de la fréquence du signal pour que la fréquence du capteur ou un multiple entier de celle-ci se distingue de la fréquence du signal.

**9.** Montage de capteur de courant selon l'une des revendications 5 à 8, selon lequel
l'installation de commande est réalisée pour varier l'amplitude en tension de la source de tension et varier ainsi la fréquence du capteur.

**10.** Montage de capteur de courant selon l'une des revendications 5 à 9,
selon lequel
l'installation de commande est réalisée pour varier l'instant de l'inversion de polarité de la source de tension pour varier la fréquence du capteur.

**11.** Procédé de mesure d'un courant primaire dans un conducteur primaire couplé magnétiquement à un conducteur secondaire par un noyau ferromagnétique,
procédé comprenant les étapes suivantes :

- application d'une tension d'une amplitude donnée au conducteur secondaire pour que le courant secondaire traverse le noyau ferromagnétique pour inverser l'aimantation,
- mesure du courant secondaire pendant l'inversion d'aimantation du noyau pour obtenir une première valeur de mesure,
- changement de polarité de la tension pour qu'un courant secondaire traverse le noyau ferromagnétique pour inverser l'aimantation de nouveau,
- mesure du courant secondaire pendant l'inversion d'aimantation du noyau pour obtenir une seconde valeur de mesure,
- calcul du courant primaire en fonction de la première et de la seconde valeur de mesure,

procédé selon lequel
on effectue au moins une fois le changement de polarité à un instant qui précède l'instant auquel le noyau ferromagnétique a atteint sa saturation magnétique de façon à ne pas avoir à parcourir toute la boucle d'hystérésis de la courbe caractéristique d'aimantation.

**12.** Procédé selon la revendication 11,
selon lequel
on effectue au moins une fois le changement de polarité à l'instant auquel le noyau ferromagnétique atteint son aimantation de saturation.

**13.** Procédé selon la revendication 11,
selon lequel

on coupe au moins une fois la source de tension à l'instant auquel le noyau ferromagnétique atteint sa saturation magnétique et à la fin d'un temps de pause, on branche de nouveau la source de tension avec inversion de polarité.

14. Procédé selon l'une des revendications 11 à 13,
   selon lequel

   - le courant secondaire est fourni par un circuit source de tension, le procédé comprenant en outre les étapes suivantes :
   - filtrage du courant d'alimentation du circuit de la source de tension pour limiter le courant de charge maximum fourni par la source de tension d'alimentation.

15. Procédé selon l'une des revendications 11 à 14,
   selon lequel
   on effectue régulièrement le changement de polarité de la tension à une fréquence de capteur déterminée et on varie en continu la fréquence de capteur.

16. Procédé selon la revendication 15,
   selon lequel
   on varie de manière stochastique la fréquence de capteur.

17. Procédé selon la revendication 15,
   selon lequel
   on varie la fréquence de capteur selon un motif de fréquence déterminé.

FIG. 1a

FIG. 1b

Magnetisierung M

Sättigungsmagnetisierung $M_{SAT}$ ........

mag. Feldstärke H
= $N \cdot i_S / l_{FE}$

Koerzitivfeldstärke $H_C$

# FIG. 2a

Sekundärstrom $i_S$    Umpolen    Umpolen

Magnetisierungsstrom $i_\mu$

$+i_{SMAX}$

abtasten    abtasten    abtasten    abtasten    abtasten

$-i_\mu$

Zeit t

positive        negative
Sättigung       Sättigung

$-i_{SMAX}$

$\Delta t_+$    $\Delta t_-$

$1/f_{SENSOR}$

# FIG. 2b

Magnetisierung M

Sättigungsmagnetisierung $M_{SAT}$

mag. Feldstärke H
= $N \cdot i_S / l_{FE}$

$i_P / l_{FE}$

# FIG. 3a

Sekundärstrom $i_S$    Umpolen    Umpolen

$i_P/N + i_\mu$

$+i_{SMAX}$

$i_P/N - i_\mu$

$i_P/N$

Zeit t

$-i_{SMAX}$

positive      negative      $1/f_{SENSOR}$
Sättigung     Sättigung

# FIG. 3b

FIG. 4

Magnetisierung M

Sättigungsmagnetisierung $M_{SAT}$

$\Delta M$

mag. Feldstärke H
$= N \cdot i_S / I_{FE}$

Koerzitivfeldstärke $H_C$

# FIG. 5a

Sekundärstrom $i_S$

Umpolen Umpolen

Magnetisierungs strom $i_\mu$

abtasten

abtasten

$-i_\mu$

Zeit t

negative Sättigung

$\Delta t_+$

$-i_{SMAX}$

$1/f_{SENSOR}$

$t_0$  $t_1$  $t_3$

# FIG. 5b

FIG. 5c

Primärstrom $i_P$

Primärwicklung 1

ü = 1:N                    ferromagnetischer Kern 10

Sekundärwicklung 2
$u_i$

$U_B$

$U_B$

LP

REG

I/O Port 1
I/O Port 2

A1

A2

$U_{REF}$

K

OP

gesteuerte Spannungsquelle Q

$R_{SH}$    $U_{SH}$

GND

GND    Mess- und Steuereinheit 20

# FIG. 6

FIG. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4229948